Europäisches Patentamt

European Patent Office

Office européen des brevets

(19)

(11) Publication number: **0 326 293**
**A1**

## (12) EUROPEAN PATENT APPLICATION

(21) Application number: **89300548.8**

(51) Int. Cl.⁴: **H01L 21/90**

(22) Date of filing: **20.01.89**

(30) Priority: **27.01.88 US 148803**

(43) Date of publication of application:
**02.08.89 Bulletin 89/31**

(84) Designated Contracting States:
**AT BE CH DE ES FR GB GR IT LI LU NL SE**

(71) Applicant: **ADVANCED MICRO DEVICES, INC.**
**901 Thompson Place P.O. Box 3453**
**Sunnyvale, CA 94088(US)**

(72) Inventor: **Haskell, Jacob D.**
**1301 Forest Avenue**
**Palo Alto California 94301(US)**

(74) Representative: **Wright, Hugh Ronald et al**
**Brookes & Martin 52/54 High Holborn**
**London WC1V 6SE(GB)**

(54) **Method for forming interconnects.**

(57) A double metal contact structure comprising two layers of metal interconnects (14, 20) is formed by planarizing the first metal layer, using a planarizing dielectric material (26) between the contacts. A first dielectric layer (28), which serves as an etch stop, is formed over the planarized surface. A second dielectric layer (30) is formed over the etch stop layer. The second metal layer is formed by first etching contact holes (10) down through the two dielectric layers, employing a two-step etch process that is first selective to the second dielectric layer and then is selective to the first dielectric layer, thereby stopping at the top surface of the first metal layer. The process of the invention avoids gouging problems experienced with prior art approaches, with consequent shorting of upper metal layers to buried structures (18) and permits closer placement of contact structures (20a) than permitted by prior art processes.

Fig. 10

## METHOD FOR FORMING METAL INTERCONNECTS

The present invention relates to semiconductors, and, more particularly, to contacts for semiconductor devices.

A number of contact schemes for semiconductor devices are well-known. Various metals in a variety of combinations and configurations are used in an effort to improve device performance.

While such schemes have largely been successful, efforts continue to develop contact configurations which simplify manufacturing processes, are lower in cost, and offer a simpler construction without sacrificing device performance.

One problem for which a solution has long been sought is the tendency of gouging of an oxide lying under a metal if the contact is misaligned with the underlying metal layer.

Problems in the past when making a contact to a first level interconnect have necessitated the forma tion of a "dogbone" where the contact is to be made to the interconnect, so that a mis-aligned contact would not short to the underlying structures. This is especially a problem where the depths of the oxide to be etched are variable. For example, in a field effect transistor (FET), a contact to the first level interconnect over field oxide is different than a contact to a first level interconnect over a source or drain region.

We will describe a process for forming multi-level metal interconnects to lower metal layers which avoids gouging through lower levels in the event of misalignment of upper level contacts to lower level contacts.

We will describe a process which permits closer tolerance spacing of upper level and lower level contacts.

We will describe a multi-level contact structure which avoids shorting to unintended buried levels in spite of possible misalignment of contacts.

We will describe a multi-level metal contact structure comprising two layers of metal contact areas formed by planarizing the first metal contact areas, using a planarizing dielectric material between the contact areas. A first dielectric layer, which serves as an etch stop, is formed over the planarized surface. A second dielectric layer is formed over the etch stop layer. The second metal layer is formed by first etching contact holes down through the two dielectric layers, employing a two-step etch pro cess that is first selective to the second dielectric layer and then is selective to the first dielectric layer, thereby stopping at the top surface of the first metal layer.

We will describe a process for forming at least one additional level of metal interconnect to contact a lower level of metal in a semiconductor device comprises:

(a) forming the lower level of metal and patterning the metal to form isolated contact areas;

(b) filling regions between the isolated contact areas with a dielectric material and planarizing the resulting structure to the top surface of the isolated contacts;

(c) forming a first dielectric layer on the planarized layer;

(d) forming a second dielectric layer on the first dielectric layer;

(e) etching contact holes through both the dielectric layers in a two-step process that comprises etching the second dielectric layer with an etchant that selectively etches the second dielectric layer relative to the first dielectric layer to expose portions of the first dielectric layer and then etching the first dielectric layer with an etchant that selectively etches the first dielectric layer relative to the dielectric material isolating the lower level metal contacts to expose at least a portion of the lower level metal contact areas; and

(f) forming the additional level of metal interconnect over the second dielectric layer and into the contact holes to contact the lower level metal contact.

The preferred process of the invention avoids gouging problems experienced with prior art approaches, with consequent shorting of upper metal layers to buried structures and permits closer placement of contact structures than permitted by prior art processes.

Other objects, features and advantages of the present invention will become apparent upon consideration of the following detailed description and accompanying drawings, in which like reference designations represent like features throughout the FIGURES.

## BRIEF DESCRIPTION OF THE DRAWINGS

The drawings referred to in this description should be understood as not being drawn to scale except if specifically noted. Moreover, the drawings are intended to illustrate only one portion of an integrated circuit fabricated in accordance with the present invention.

FIG. 1 depicts, in cross-section, a problem typically encountered in the prior art when misalignment occurs during fabrication of multi-level metal interconnects;

FIG. 2 is a top plan view of the interconnect shown in FIG. 1, illustrating misalignment of the contact, which laps over one side;

FIG. 3 is a top plan view, illustrating one prior art approach to solving misalignment problems, but which requires additional area of the device for implementation;

FIGS. 4-10 depict, in cross-section, the fabrication of a multi-level metal interconnect scheme in accordance with the invention;

FIGS. 11 and 12 are top plan views of the interconnect fabricated in accordance with the invention, illustrating that misalignment does not materially affect the device; and

FIG. 13 is a cross-sectional view depicting extension of the principles of the invention to multi-level metal interconnect structures.

## DETAILED DESCRIPTION OF THE INVENTION

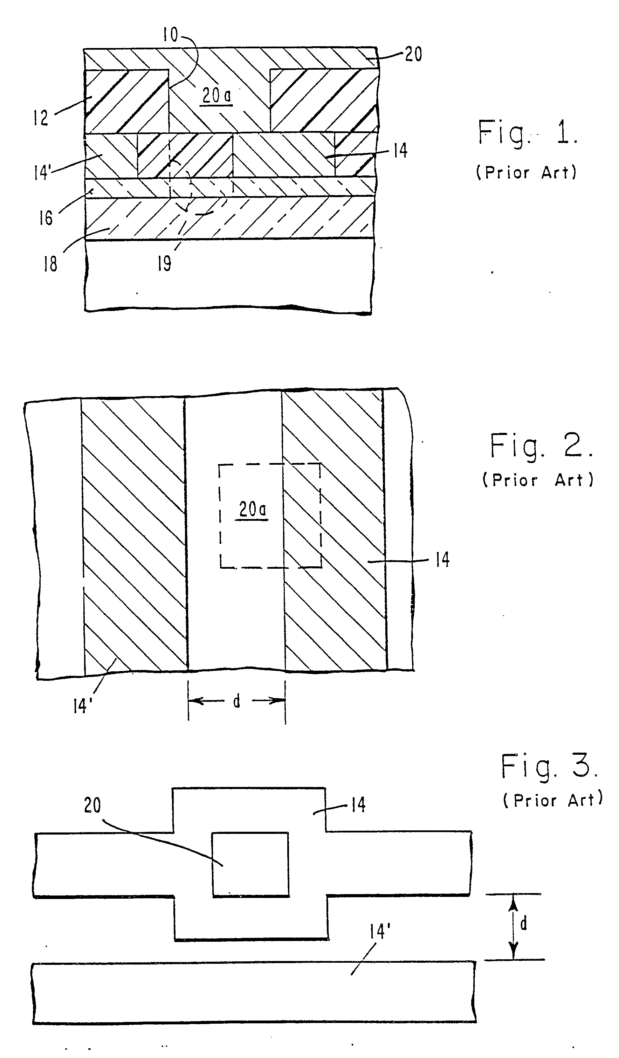

FIG. 1 depicts the effects of misalignment of an attempt to form a contact hole 10 in an inter-level dielectric layer 12 to an underlying patterned first metal interconnect 14. Offset of the contact hole 10 to one side of the metal interconnect 14 is seen to result in etching through any material adjacent the metal interconnect, such as an oxide or glass layer 16 down to a buried structure 18, such as polysilicon, for example. The resultant gouge 19 is depicted by dashed lines. Deposition of a second metal contact 20a would fill the contact hole 10, shorting the buried structure 18 to the metal interconnect 14 and contact 20a.

FIG. 2 shows a top plan view of the offset. One common approach in the prior art is to form a "landing pad" structure, as shown in FIG. 3. However, such a structure uses up extra area and prohibits using tight spacing d between adjacent interconnects 14 and 14'.

Reference is now made in detail to a specific embodiment of the present invention, which illustrates the best mode presently contemplated by the inventor for practicing the invention. Alternative embodiments are also briefly described as applicable.

Semiconductor wafers having a plurality of devices formed thereon are processed to the point of a first level interconnect. The nature of the devices and the processing to the first level interconnect are immaterial and hence do not form a part of this invention. The process of the invention is suitable for any semi-conductor device requiring more than one level of interconnect.

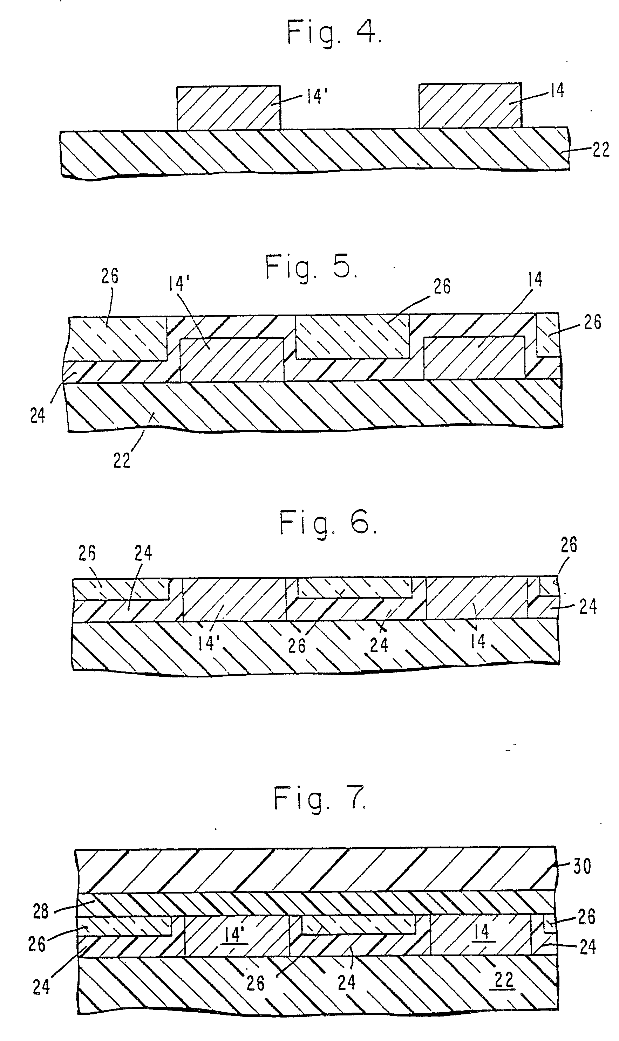

FIG. 4 depicts the resulting wafer following formation and patterning of the first level interconnect 14. The details of the device itself are omitted, it being assumed that the first level interconnect 14 is formed on an inter-level dielectric layer 22. In the application of the invention, the composition and thickness of the inter-level dielectric layer 22 are conventional and hence again do not form a part of the invention. As an example, for silicon-based semiconductor devices, the inter-level dielectric layer 22 typically comprises silicon dioxide. Other oxides or other dielectric materials may be used for silicon or other semiconductor devices. Also, the dimensions and composition of the first level interconnect 14 and second level interconnect 20, as well as any additional level interconnects 20', are conventional and well-known to those skilled in this art.

A first oxide layer 24, is blanket deposited over the entire surface, covering both the first level interconnect 14 and any exposed portions of the inter-level dielectric layer 22. The first oxide layer 24 is formed to a thickness ranging from about 6,000 to 8,000 Å. The thickness of the first oxide layer 24 is a trade-off between a desire for a thicker layer, and hence increased capacitance between the first level interconnect 14 and the second level interconnect 20, and the desire for a relatively thin layer for reduced process times to etch contact holes and to fill the contact holes with the second level interconnect metal.

Advantageously, the first oxide layer 24 is formed by PECVD (plasma-enhanced chemical vapor deposition), employing well-known process parameters for the deposition. For deposition onto aluminum interconnects, the process temperature should be maintained below about 400°C. Any low temperature glass may be employed for this oxide layer 24.

Next, all exposed areas between the first level interconnects 14 are filled with a glass, such as spin-on glass, to form layer 26. The resulting structure is shown in FIG. 5. In this manner, the metal portions 14 are physically and electrically isolated from each other. The coated wafer is planarized back to the metal interconnect surface, denoted 14a, as shown in FIG. 6, employing any of the procedures well-known in the art.

While it may be advantageous to employ both a PECVD oxide layer 24 and a spin-on glass layer 26, it is not essential to the practice of the invention. Although planarization is facilitated by the combination, it will be appreciated that for openings less than about 0.5 μm, PECVD is not feasible due to the formation of voids. In such cases, spin-on glass would be used alone.

A nitride layer 28, e.g., silicon nitride, is next deposited; this layer serves as an etch-stop for subsequent etching processes described below. The nitride, which is conveniently deposited by PECVD, is formed to a thickness of about 400 to 800 Å. Other non-conducting materials which would also comprise an etch-stop may be used in place of silicon nitride.

An inter-level oxide layer 30 is deposited; this layer serves as a patterning layer for the subsequent etching. The oxide layer 30 is deposited to a thickness of about 6,000 to 8,000 Å, as with the deposition of layer 24. The resulting structure is shown in FIG. 7.

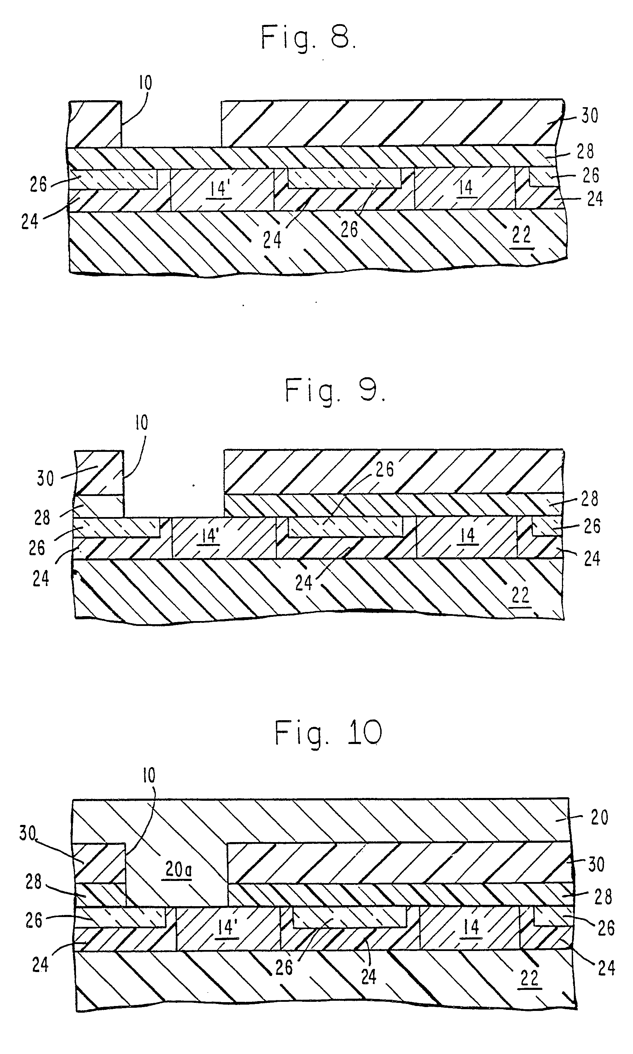

The oxide layer 30 is then masked with a resist layer (not shown) and etched to form contact holes 10 to the underlying first level interconnect 14. The etching is done in two steps. In the first step, the oxide layer 30 is etched, stopping on the underlying nitride layer 28, as depicted in FIG. 8. The nitride layer 28 is then etched, stopping on the underlying oxide 24 and/or metal 14, depending on the placement of the contact holes 10 being etched, as shown in FIG. 9.

Fluorocarbon plasma etching is advantageously employed in the two-step etching process, since adjustment in chemistry permits selective etching of oxide and then nitride, as is well-known. For example, the selectivity of oxide in layer 30 to nitride in layer 28 should be at least about 5:1, in order to allow for a 25% process non-uniformity. On the other hand, the selectivity of the nitride in layer 28 to the oxide in layer 24 need only be at least about 3:1, since the nitride layer is much thinner than the oxide layer and thus the percent non-uniformity is smaller.

The resist layer is then stripped. The second level metal layer 20 is then deposited and patterned, as is conventional. The resulting two layer metal interconnect fabricated in accordance with the process of the invention is depicted in FIG. 10.

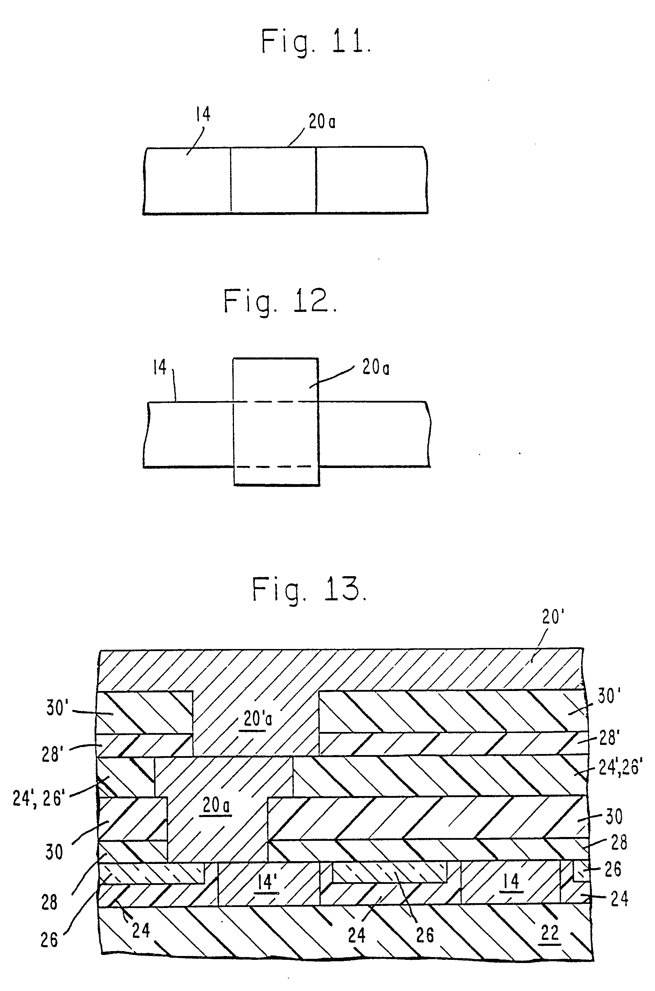

The advantages provided by the invention include permitting the contact 20a and the first level metal 14 can be of the same size or the contact can be larger than the metal. Thus, as seen in FIGS. 11 and 12, there is no over-etch problem even if the contact 20a is mis-aligned with the metal 14. Also, it will be appreciated that the resulting metal area to form the contact is less than the prior art "dogbone", or "framed", contact.

The reason for the immateriality of contact mis-alignment is that the etch stop layer 28 prevents the oxide etch (through the oxide 30 between the interconnect levels) from penetrating and forming a gouge 19, as in FIG. 1. This is demonstrated in FIG. 8. Having stopped on the nitride layer 28, the switch to a nitride etch does not etch the underlying oxide layers 24, 26 and prevents the gouge 19 from forming.

Any conducting material may be employed for the first metal layer 14 and the second metal layer 20. While aluminum is conventionally employed in silicon semiconductor devices, other conducting materials, such as tungsten, molybdenum, and others well-known in the art may alternatively be used.

It will be appreciated that the process of the invention can be extended to several layers of inter-connects, as depicted in FIG. 13. The two layer construction of thin etch stop layer overlaid by a dielectric layer is replicated for as many inter-level metallic interconnects as needed. The layers corresponding to earlier formed layers are denoted by the same number, primed (e.g., 28′).

The foregoing description of the preferred embodiment of the present invention has been presented for purposes of illustration and description. It is not intended to be exhaustive or to limit the invention to the precise form disclosed. Obviously, many modifica tions and variations will be apparent to practitioners skilled in this art. It is possible that the invention may be practiced in other fabrication technologies in MOS or bipolar processes. Similarly, any process steps described might be interchangeable with other steps in order to achieve the same result. The embodiment was chosen and described in order to best explain the principles of the invention and its practical application, thereby enabling others skilled in the art to understand the invention for various embodiments and with various modifications as are suited to the particular use contemplated. It is intended that the scope of the invention be defined by the claims appended hereto and their equivalents.

## Claims

1. A process for forming at least one additional level of metal interconnect to contact a lower level of metal in a semiconductor device, comprising:

(a) forming said lower level of metal and patterning said metal to form isolated contact areas;

(b) filling regions between said isolated contact areas with a dielectric material and planarizing the resulting structure to the top surface of said isolated contact areas;

(c) forming a first dielectric layer on said planarized layer;

(d) forming a second dielectric layer on said first dielectric layer;

(e) etching contact holes through both said dielectric layers in a two-step process that comprises etching said second dielectric layer with an etchant that selectively etches said second dielectric layer relative to said first dielectric layer to expose portions of said first dielectric layer and then etching said first dielectric layer with an etchant that selectively etches said first dielectric layer relative to said dielectric material isolating said lower level metal contact areas to expose at least a portion of said lower level metal contact areas; and

(f) forming said at least one additional level of metal interconnect over said second dielectric layer and into said contact holes to contact said lower level metal contact area.

2. The process of Claim 1 wherein said first dielectric layer consists essentially of silicon nitride.

3. The process of Claim 1 wherein said second dielectric layer consists essentially of silicon dioxide.

4. A process for forming at least one additional level of metal interconnect to contact a lower level of metal in a silicon semiconductor device, comprising:

(a) forming said lower level of metal and patterning said metal to form isolated contact areas;

(b) filling regions between said isolated contact areas with silicon dioxide and planarizing the resulting structure to the top surface of said isolated contact areas;

(c) forming a first dielectric layer consisting essentially of silicon nitride on said planarized layer;

(d) forming a second dielectric layer consisting essentially of silicon dioxide on said first dielectric layer;

(e) etching contact holes through both said dielectric layers in a two-step process that comprises etching said second dielectric layer with an etchant that selectively etches said second dielectric layer relative to said first dielectric layer to expose portions of said first dielectric layer and then etching said first dielectric layer with an etchant that selectively etches said first dielectric layer relative to said. dielectric material isolating said lower level metal contacts to expose at least a portion of said lower level metal contacts; and

(f) forming said at least one additional level of metal interconnect over said second dielectric layer and into said contact holes to contact said lowe level metal contact area.

5. The process of Claim 1 or 3 wheren additional levels of metal interconnects are formed to lower level metal layers employing the formation of said two dielectric layers and said two-step etching process to form said contact holes.

6. The process of Claim 1 or 3 wherein said dielectric material comprises at least one layer of silicon dioxide.

7. The process. of Claim 2 or 4 wherein said silicon nitride layer is formed to a thickness ranging from about 400 to 800 A.

8. The process of Claim 3 or 4 wherein said silicon dioxide layer is formed to a thickness ranging from about 6,000 to 8,000 A.

9. A structure comprising at least two metal interconnect layers (14,20) separated vertically from each other by two dielectric layers (28,30), a first etch-stop layer (28) formed on a lower metal layer (14) and a second layer (30) formed on said first layer, with an upper metal layer (20) formed on said second layer, with contact holes (10) between each metal layer filled with metal (20a) of said upper layer and contacting metal of said lower layer.

10. The structure of Claim 9 wherein said first dielectric layer consists essentially of silicon nitride.

11. The structure of Claim 9 wherein said second dielectric layer consists essentially of silicon dioxide.

12. A structure comprising at least two metal interconnect layers (14,20) separated vertically from each other by two dielectric layers (28,30), a first etch-stop layer (28) consisting essentially of silicon nitride formed on a lower metal layer (14) and a second layer (30) consisting essentially of silicon dioxide formed on said first layer, with an upper metal layer (20) formed on said second layer, with contact holes (10) between each metal layer filled with metal (20a) of said upper layer and contacting metal of said lower layer.

13. The structure of Claim 9 or 12 comprising additional metal interconnect layers (20$'$), each layer separated vertically from the other by said two dielectric layers (28$'$, 30$'$), with contact holes between each metal layer filled with metal of an upper layer and contacting metal of a lower layer.

14. The structure of Claim 13 wherein each said lower layer comprises patterned metal contact areas, with regions between said metal contact areas filled with a dielectric material (24,26).

15. The structure of claim 14 wherein said dielectric material comprises at least one layer of silicon dioxide.

16. The structure of claim 10 or 12 wherein said silicon nitride layer has a thickness ranging from about 400 to 800 A.

17. The structure of Claim 11 or 16 wherein said silicon dioxide layer has a thickness ranging from about 6,000 to 8,000 A.

Fig. 1.
(Prior Art)

Fig. 2.
(Prior Art)

Fig. 3.
(Prior Art)

## Fig. 4.

14'    14    22

## Fig. 5.

26    14'    26    14    26    24    22'

## Fig. 6.

26    24    26    14'    26    24    14    24

## Fig. 7.

30    28    26    14'    14    26    24    26    22    24

Fig. 8.

Fig. 9.

Fig. 10

# Fig. 11.

14    20a

# Fig. 12.

14    20a

# Fig. 13.

20'

30'    20'a    30'

28'    28'

24', 26'    24',26'

20a    30

28

14'    26

24    14    24

26    24    26    22

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | EP-A-0 241 729 (GENERAL ELECTRIC CO.) * Figures 1-10; column 3, line 51 - column 6, line 12 * | 1,9 | H 01 L 21/90 |
| Y | | 4,12 | |
| A | * Column 6, lines 51-56 * | 5,13,14 ,15 | |
| Y | S.J. MOSS et al.: "The chemistry of the semiconductor industry", 1987, pages 374-378 Blackie & Son, Ltd, Glasgow, London, GB * Plasma etching of silicon dioxide and silicon nitride; pages 374-378, especially table 15.3 * | 4,12 | |
| A | IDEM | 2,3,6, 10,11 | |
| A | IBM TECHNICAL DISCLOSURE BULLETIN, vol. 27, no. 7A, December 1984, pages 3990-3993, New York, US; C. ALCORN et al.: "Self-aligned silicon nitride-polyimide double step via hole" * Whole article * | 1,2,4,9 ,10,12 | TECHNICAL FIELDS SEARCHED (Int. Cl.4) H 01 L |
| A | EP-A-0 154 419 (FUJITSU) * Abstract; figures 1,2 * | 1,4,9, 12,14, 15 | |

--- -/-

The present search report has been drawn up for all claims

| Place of search | Date of completion of the search | Examiner |
|---|---|---|
| THE HAGUE | 11-05-1989 | MACHEK,J. |

European Patent
Office

EUROPEAN SEARCH REPORT

Application Number

EP  89 30 0548

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 4) |
|---|---|---|---|
| A | FOURTH INTERNATIONAL IEEE VLSI MULTILEVEL INTERCONNECTION CONFERENCE, Santa Clara, 15th-16th June 1987, pages 376-384, IEEE, New York, US; R.M. BREWER et al.: "Process window calculations for an SOG etch back process" <br> * Whole article * <br> ----- | 1,4,9, 12,14, 15 | |

TECHNICAL FIELDS SEARCHED (Int. Cl.4)

The present search report has been drawn up for all claims

| Place of search | Date of completion of the search | Examiner |
|---|---|---|
| THE HAGUE | 11-05-1989 | MACHEK,J. |

EPO FORM 1503 03.82 (P0401)